(19) Europäisches Patentamt
European Patent Office
Office européen des brevets

(11) **EP 1 366 564 B1**

(12) **EUROPÄISCHE PATENTSCHRIFT**

(45) Veröffentlichungstag und Bekanntmachung des Hinweises auf die Patenterteilung:
**09.04.2008 Patentblatt 2008/15**

(21) Anmeldenummer: **02712914.7**

(22) Anmeldetag: **14.02.2002**

(51) Int Cl.:
*H03G 3/32* (2006.01)    *H03G 5/16* (2006.01)

(86) Internationale Anmeldenummer:
**PCT/EP2002/001591**

(87) Internationale Veröffentlichungsnummer:
**WO 2002/067418 (29.08.2002 Gazette 2002/35)**

(54) **VORRICHTUNG ZUM GERÄUSCHABHÄNGIGEN EINSTELLEN DER LAUTSTÄRKEN**

DEVICE FOR THE NOISE-DEPENDENT ADJUSTMENT OF SOUND VOLUMES

DISPOSITIF PERMETTANT LA REGULATION DE L'INTENSITE SONORE INDEPENDAMMENT DU BRUIT

(84) Benannte Vertragsstaaten:
**DE FR GB IT**

(30) Priorität: **16.02.2001 DE 10107385**

(43) Veröffentlichungstag der Anmeldung:
**03.12.2003 Patentblatt 2003/49**

(73) Patentinhaber: **Harman Becker Automotive Systems GmbH**
**76307 Karlsbad (DE)**

(72) Erfinder: **CHRISTOPH, Markus**
**94315 Straubing (DE)**

(74) Vertreter: **Schmuckermaier, Bernhard**
**Herzog-Wilhelm-Str. 26**
**80331 München (DE)**

(56) Entgegenhaltungen:
**EP-A- 0 319 777        DE-A- 19 832 472**
**US-A- 5 034 984**

• **PATENT ABSTRACTS OF JAPAN vol. 1999, no. 13, 30. November 1999 (1999-11-30) & JP 11 225030 A (MATSUSHITA ELECTRIC IND CO LTD), 17. August 1999 (1999-08-17)**

**Beschreibung**

Die Erfindung betrifft eine Vorrichtung zum geräuschabhängigen Einstellen der Lautstärke eines aus einer Signalquelle mit einem elektrischen Nutzsignal gespeisten Lautsprechers an einem mit Geräusch erfüllten Abhörort.

Wenn Musik oder Sprache über eine elektroakustische Anlage in einer geräuscherfüllten Umgebung dargeboten wird, ist in der Regel der Hörgenuss durch das Hintergrundgeräusch getrübt. Ein lärmerfüllter Raum, an dem häufig Musik und Sprache abgehört wird, ist beispielsweise der Innenraum eines Kraftfahrzeuges. Das Hintergrundgeräusch kann dabei vom Motor, von den Reifen, vom Gebläse und anderen Aggregaten in den Kraftfahrzeug herrühren und daher von der Geschwindigkeit, den Straßenbedingungen und den Betriebszuständen im Kraftfahrzeug abhängen.

Dieser zeitlich sich ändernden Geräuschkulisse wird ein Kraftfahrzeuginsasse beispielsweise dadurch begegnen, dass er in Form von Musik und Sprache dargebotene Nutzsignale entsprechend durch Drehen am Lautstärkeregler anpasst. Jedoch ist durch eine einfache Lautstärkeerhöhung das Problem nicht zu lösen, weil dann ein Verlust bei der Wahrnehmung der Bässe auftritt. Durch das unerwünschte Hintergrundgeräusch im Fahrzeug werden erwünschte Nutzsignale überdeckt, was zu einer Veränderung des wahrgenommen Klanges führt.

Aus der US 5,034,984 ist eine Anordnung bekannt, bei der zwischen Signalquelle und Lautsprecher zwei Lautstärkesteller geschaltet sind, von denen der eine manuell und der andere durch ein bestimmtes Steuersignal steuerbar ist. Dieses Steuersignal wird aus der Fahrzeuggeschwindigkeit abgeleitet. Dabei wird von der Annahme ausgegangen, dass die Geschwindigkeit in etwa den Geräuschpegel im Fahrzeug repräsentiert. Allerdings ist die Geschwindigkeit nur ein sehr ungenauer Repräsentant des Geräusches, denn bei gleicher Geschwindigkeit ist die Geräuschkulisse beispielsweise auf Asphalt, Kopfsteinpflaster, Schotter sehr unterschiedlich.

Daher wird beispielsweise in der US 4,944,018 in anderem Zusammenhang vorgeschlagen, zusätzlich andere Geräusche repräsentierende Signale des Fahrzeuges wie beispielsweise die Motordrehzahl oder den Betriebszustand eines Gebläses zu erfassen. Aber auch diese Faktoren geben nur in verhältnismässig geringem Umfang Aufschluss über die tatsächliche Geräuschkulisse im Fahrzeug. Insbesondere werden dabei äussere Faktoren wie der bereits genannte Fahrbahnbelag nicht berücksichtigt, obwohl dieser einen massgeblichen Anteil auf die Fahrzeuginnengeräusche hat. Aus der DE 198 32 472, der JP 11-225030, der EP 0 319 777 und der US 4,677,389 sind ähnliche Vorrichtungen bekannt.

Aufgabe der Erfindung ist es daher, eine Anordnung der eingangs genannten Art anzugeben, die eine verbesserte Anpassung der Lautstärke an die tatsächliche Geräuschkulisse bietet.

Die Aufgabe wird gelöst durch eine Anordnung gemäss Patentanspruch 1. Ausgestaltungen und Weiterbildungen des Erfindungsgedankens sind Gegenstand von Unteransprüchen.

Im einzelnen weist die erfindungsgemässe Vorrichtung zwei in Reihe zueinander sowie zwischen Signalquelle und Lautsprecher geschaltete Lautstärkesteller auf, von denen der eine (direkt oder indirekt) manuell steuerbar ist und der andere durch ein Steuersignal (automatisch) steuerbar ist. Weiterhin ist ein Geräuschdetektor zum Ermitteln des Pegels des Geräusches und zum Erzeugen eines Steuersignals für den anderen Lautstärkesteller entsprechend dem Geräuschpegel vorgesehen.

Auf diese Weise lässt sich auf einfache Weise der gewünschte Pegel bei einer bestimmten Geräuschsituation von Hand einstellen, der dann bei sich ändernder Geräuschsituation automatisch entsprechend angepasst wird. Die Trennung zwischen manueller und automatischer Lautstärkeeinstellung hat darüber hinaus den Vorteil, dass eine üblicherweise vorgesehene gehörrichtige Anpassung des Klanges bei niedrigen Lautstärken einfach und wirkungsvoll vorgenommen werden kann.

Obwohl der exakte Verlauf des Geräuschsignals über der Frequenz nicht vorhergesagt werden kann, ergibt sich doch in der Regel ein Verlauf der dem von Rosarauschen entspricht. Je nachdem, ob ein oder mehrere Fenster des Fahrzeuges offen oder geschlossen sind, ob die Lüftung im Fahrzeug angeschaltet ist, auf welcher Stufe die Lüftung betrieben wird und in welche Richtung das Gebläse momentan wirkt, ergeben sich selbstverständlich Verschiebungen des Rauschspektrums, jedoch bleibt der prinzipielle Verlauf, der dem von Rosarauschen entspricht, erhalten. Rosarauschen bedeutet, dass die Hauptenergie des Spektrums im tieffrequenten Spektralbereich angesiedelt ist und hin zu hohen Frequenzen abnimmt.

Da fahrzeugtypische Geräusche einen sehr hohen Energieanteil im niederfrequenten Spektralbereich aufweisen, kommt es dort auch zu stärkeren spektralen Verdeckungen als in den restlichen Spektralbereichen. Durch geeignete gehörrichtige Anpassung der Übertragungsfunktion, insbesondere durch das Anheben bei tiefen Tönen, können diese Verdeckungseffekte weitgehend kompensiert werden. Die erfindungsgemäße Verwendung von zwei getrennten Lautstärkestellern hat dabei den vorteilhaften Effekt, das mit dem einen Lautstärkeregler die vom Bediener gewünschte Lautstärke eingestellt wird, wobei gleichzeitig auch die entsprechende gehörrichtige Anpassung (entsprechen einer Loudnesskurve) mit eingestellt wird. Der zweite Lautstärkeregler wird ausschließlich abhängig vom Geräuschpegel dynamisch gesteuert. Als Ergebnis wird dabei in sehr guter Näherung eine Anpassung an die Eigenschaften des menschlichen Gehörs erreicht.

Die Wirkung ist dabei wie folgt: stellt ein Bediener eine gewisse Lautstärke im Fahrzeug ein, so erfolgt auch eine gehörrichtige Anpassung gemäß einer korrespondierenden Loudnesskurve. Je niedriger nun die Lautstärke vom Bediener gewählt wird, umso mehr wird der Bassbereich angehoben. Je höher umgekehrt die Lautstärke vom Bediener gewählt wird, umso weniger wird der Bass angehoben. Wird nun beispielsweise eine relativ geringe Lautstärke vom Bediener gewählt, so wird eine relativ große Bassanhebung erzeugt. Steigt nun der Geräuschpegel im Fahrzeug bedingt durch etwa einen Fahrbahnbelagswechsel, durch Öffnen eines Fensters, durch Einschalten der Lüftung, Erhöhung der Geschwindigkeit, Ausfahren der einzelnen Gänge usw. an, so wird die Lautstärke mit Hilfe des zweiten Lautstärkestellers, der dabei vor oder nach dem ersten Lautstärkestellers angebracht sein kann, erhöht.

Dabei bleibt aber die durch den manuellen Lautstärkesteller festgelegte Loudnesskurve unverändert beibehalten, so dass es insgesamt bei einer Geräuschpegelzunahme zu einer gegenüber der Loudnesskurve ohne Geräuscheinwirkung verstärkten Anhebung der Bässe kommt. Da aber -wie bereits oben erläuterteine Geräuschpegelzunahme in Kraftfahrzeugen üblicherweise einer stärkeren Verdeckung der tieffrequenten Frequenzanteile gleichkommt (Rosa Rauschen), müssen gerade diese Frequenzanteile verstärkt bzw. angehoben werden. Damit wird erreicht, dass der Bediener unabhängig davon, welche Geräuschsituation auftritt, immer denselben Klangeindruck vor allem im Bassbereich erlebt.

Eine übliche Loudnesskurve hat eine Grenzfrequenz bei ca. 50 Hertz, was jedoch bei einer typischen Geräuscheinwirkung im Fahrzeug als zu niedrig anzusehen ist. Daher wird bevorzugt die vorhandene Loudnesskurvenschar in Abhängigkeit des vorherrschenden Rauschpegels korrigiert. Dabei kann die Korrektur in Abhängigkeit des momentan vorherrschenden Geräuschpegels beispielsweise durch Abändern der Filtergüte, der Filtergrenzfrequenz oder aber auch durch Zuschalten eines oder mehrerer Filter geschehen.

Die Erfindung weiterbildend ist also der manuell steuerbare Lautstärkesteller mit einer Einrichtung zum gehörrichtigen Anpassen der Übertragungsfunktion zwischen Signalquelle und Lautsprecher an die eingestellte Lautstärke gekoppelt und/oder eine Einrichtung zum gehörrichtigen Anpassen der Übertragungsfunktion zwischen Signalquelle und Lautsprecher geschaltet, wobei die Einrichtung zum gehörrichtigen Anpassen durch mindestens ein (weiteres) Steuersignal des Geräuschdetektors gesteuert wird.

Die Einrichtung zum gehörrichtigen Anpassen der Übertragungsfunktion kann dabei mindestens zwei Filter (z. B. Bandpässe) mit unterschiedlichen Grenzbzw. Mittenfrequenzen aufweisen, die durch (jeweils) ein Steuersignal des Geräuschdetektors gesteuert werden. Die beiden Bandpässe können dabei entweder durch ein einziges gemeinsames Signal gesteuert werden oder aber durch zwei unterschiedliche vom Geräuschdetektor bereitgestellte Signale. Bei letzteren kann der Geräuschdetektor das Geräusch in mindestens zwei unterschiedlichen spektralen Bereichen auswerten und dann dementsprechende Steuersignale erzeugen. Auf diese Weise kann noch genauer auf spektrale Besonderheiten des Geräusches im Fahrzeuginnenraum eingegangen werden.

Eine erfindungsgemäße Möglichkeit den Geräuschpegel zu detektieren besteht darin, mit dem Lautsprecher nur akustische Nutzsignale mit Frequenzen oberhalb einer bestimmten Grenzfrequenz abzustrahlen und mit dem Geräuschdetektor nur Geräusche unterhalb dieser bestimmten Grenzfrequenz auszuwerten. Die bestimmte Grenzfrequenz wird vorzugsweise so festgelegt, dass sie am Ende des unteren menschlichen Hörbereichs angesiedelt ist, damit keine Beschneidung des Hörspektrums bei tiefen Tönen erfolgt. Eine Beschneidung der (nicht hörbaren) Tiefstbässe ist im Hinblick auf den Zuhörer sowie auf Lautsprecher und Endstufe andererseits von Vorteil.

Eine andere Möglichkeit besteht darin, dass der Geräuschdetektor Geräusche an mindestens einem Ort, an dem kein oder nur ein geringes akustisches Nutzsignal auftritt und an dem das Geräusch in einer festen Beziehung zum Geräusch am Abhörort steht, auswertet. So können beispielsweise Mikrofone eines Geräuschdetektors im Motorraum und/oder in den Radkästen und/oder im Kofferraum und/oder im Zuluftkanal angebracht werden, um beispielsweise Motorengeräusche, Fahrbahngeräusche, Windgeräusche der Karosserie und Lüftergeräusche abzubilden, wobei an den jeweiligen Orten das Nutzsignal nicht oder bzw. in so geringem Umfang auftritt, dass es vernachlässigbar ist.

Die Geräuschsituation an den jeweiligen Orten steht in einer festen Beziehung zum Geräusch im Fahrzeuginnenraum, so dass aus den Geräuschpegeln an den einzelnen Orten in sehr guter Näherung auf die Geräuschsituation im Fahrzeuginnenraum geschlossen werden kann.

Eine bevorzugte Alternative dazu besteht darin, dass der Geräuschdetektor ein sich aus akustischem Nutzsignal und Geräusch zusammensetzendes Abhörsignal am Abhörort und das von der Signalquelle direkt oder indirekt bereitgestellte elektrische Nutzsignal auswertet, wobei mittels des elektrischen Nutzsignals der Geräuschsignalanteil im Abhörsignal ermittelt und zur Erzeugung des Steuersignals für den anderen Lautstärkesteller bereitgestellt wird. Es wird folglich die Geräuschsituation am Ab-hörort direkt erfasst und dabei das akustische Nutzsignal und/oder das Geräusch aus dem Gesamtsignal bei der Auswertung extrahiert, so dass diese zur Erzeugung des Steuersignals herangezogen werden können.

Bevorzugt umfasst der Geräuschdetektor dabei einen Schallaufnehmer zur Erzeugung eines elektrischen Abhörsignals aus dem akustischen Nutzsignal und aus dem diesen überlagerten Geräusch am Abhörort, einen dem Schallaufnehmer nachgeschalteten Extrahierer zum Extrahieren des im Abhörsignal enthaltenen Geräuschanteils und eine dem Extrahierer nachgeschaltete Steuereinrichtung, die den Geräuschanteil des Abhörsignals und mindestens ein aus dem Abhörsignal abgeleitetes Signal erhält und die aus beidem das Steuersignal für den anderen Lautstärkesteller erzeugt.

Dabei kann ein aus dem Abhörsignal abgeleitetes Signal entweder dem Nutzsignalanteil des Abhörsignals oder aber der Summe aus Nutzsignalanteil und Geräuschsignalanteil des Abhörsignals entsprechen.

Das aus dem Abhörsignal abgeleitete Signal wird vorteilhafterweise durch den Extrahierer bereitgestellt, um eine höhere Genauigkeit zu erzielen.

Bevorzugte Ausgestaltungen eines Extrahierers weisen mindestens ein adaptives Filter auf. Dabei kann der Extrahierer mit der Signalquelle verbunden sein und von dieser das elektrische Nutzsignal erhalten. Alternativ kann der Extrahierer aber auch mit dem Eingang des Lautsprechers (oder beispielsweise eines ihm vorgeschalteten Verstärkers) verbunden sein und von dort das elektrische Nutzsignal erhalten.

Bei einer Weiterbildung der Erfindung umfasst das adaptive Filter eine Filtereinheit mit Verzögerungselementen und einem mit den Verzögerungselementen gekoppelten Koeffizientennetzwerk, die aus dem ihr zugeführten Abhörsignal durch Filterung ein Ausgangssignal erzeugt. Außerdem ist eine Steuereinheit zur Steuerung des Koeffizientennetzwerkes vorgesehen derart, dass das Ausgangssignal gegenüber einem Referenzsignal optimiert wird, wobei als Verzögerungselemente bevorzugt Filterelemente mit einstellbaren Phasenwinkeln vorgesehen sind und die Phasenwinkel eine verzerrte Frequenzauflösung ergebend eingestellt sind. Dabei wird das Ausgangssignal des adaptiven Filters zur Erzeugung des Steuersignals für den anderen Lautstärkesteller herangezogen. Vorteil dabei ist, dass Filter mit verzerrter Frequenzauflösung bei vergleichbarer Genauigkeit einen deutlich geringeren Aufwand erfordern als herkömmlich aufgebaute Filter.

Als Referenzsignal ist dabei das elektrische Nutzsignal vorgesehen, dass entweder dem Ausgangskreis der Signalquelle bzw. dem Eingangskreis des Lautsprechers entnommen wird.

Als Filterelemente mit einstellbaren Phasenwinkeln werden bevorzugt Allpässe vorgesehen. Die Optimierung des Ausgangssignals bei dem adaptiven Filter und insbesondere bei dem adaptiven Filter mit verzerrter Frequenzauflösung erfolgt mittels der Methode der kleinsten mittleren Fehlerquadrate (oder der Methode der verzögerten kleinsten mittleren Fehlerquadrate).

Die Einrichtung zum gehörrichtigen Anpassen der Übertragungsfunktion umfasst insbesondere eine Loudness-Filteranordnung zur Anhebung des tieferen Hörfrequenzbereiches gegenüber dem mittleren Hörfrequenzbereich auf. Die Loudness-Filteranordnung umfasst dabei beispielsweise mindestens ein Tiefpassfilter und/oder ein Bandpassfilter, das im Bereich von beispielsweise 200 Hertz angesiedelt ist und die Anhebung des tieferen Hörfrequenzbereiches bewirkt.

Die Anpassung der Loudness-Filteranordnung entsprechend der eingestellten Lautstärke und/oder vom auftretenden Geräusch kann durch Verändern der Filtergüte mindestens eines Filters (Bandpass, Tiefpass) der Loudness-Filteranordnung erfolgen. Zusätzlich oder alternativ kann auch die Filtergrenzfrequenz mindestens eines Filters (Tiefpass, Bandpass) der Loudness-Filteranordnung (außer in Abhängigkeit vom eingestellten Lautstärkepegel auch) geräuschpegelabhängig angepasst werden. Weiterhin kann zum gehörrichtigen Anpassen der Übertragungsfunktion die Loudness-Filteranordnung mindestens ein weiteres Filter zur Anhebung des tieferen Hörfrequenzbereiches gegenüber dem mittleren Hörfrequenzbereich aufweisen, wobei zum gehörrichtigen Anpassen der Übertragungsfunktion die einzelnen Filter (außer in Abhängigkeit vom eingestellten Lautstärkepegel auch) geräuschpegelabhängig zu- oder abgeschaltet werden.

Bei einer Weiterbildung der Erfindung umfasst die Einrichtung zum gehörrichtigen Anpassen der Übertragungsfunktion eine durch das elektrische Nutzsignal angesteuerte Filtereinrichtung zur frequenzselektiven Filterung des elektrischen Nutzsignals, eine der Filtereinrichtung nachgeschaltete erste steuerbare Dämpfungseinrichtung, eine ebenfalls durch das Audiosignal angesteuerte zweite steuerbare Dämpfungseinrichtung, eine mit den beiden Dämpfungseinrichtungen verbundene Addiereinrichtung zur Erzeugung eines gehörrichtigen Ausgangssignals und eine mit den beiden Dämpfungseinrichtungen verbundene Steuereinrichtung zur Steuerung der beiden Dämpfungseinrichtungen entsprechend einer vorgegeben Lautstärke.

Schließlich kann die Filtereinrichtung ein bestimmtes Phasenverhalten aufweisen, wobei eine ebenfalls durch das elektrische Nutzsignal angesteuerte Phasenschiebereinrichtung zur Erzeugung eines zur Filtereinrichtung gleichen Phasenverhaltens vorgesehen ist, welche vor die zweite Dämpfungseinrichtung geschaltet ist.

Die Erfindung wird nachfolgend anhand der in den Figuren der Zeichnung dargestellten Ausführungsbeispiele näher erläutert. Es zeigt:

Figur 1:  ein erstes allgemeines Ausführungsbeispiel einer erfindungsgemäßen Anordnung,

Figur 2:  eine alternative Ausführungsform zu der allgemeinen Ausführungsform nach Figur 1,

Figur 3:  eine Ausführungsform einer erfindungsgemäßen Anordnung unter Ausnutzung verschiedener Frequenzbereiche für Geräuschdetektion und Nutzsignal,

Figur 4:  eine Ausführungsform einer erfindungsgemäßen Anordnung mit Geräuschdetektion an unterschiedlichen Orten,

Figur 5:  eine Ausführungsform einer erfindungsgemäßen Anordnung mit Geräuschdetektion am Abhörort und Extraktion von Nutzsignalsanteil und Geräuschanteil im Abhörsignal,

Figur 6: eine Ausführungsform eines bevorzugten adaptiven Filters zur Verwendung bei der Anordnung nach Figur 5,

Figur 7: eine Einrichtung zur gehörrichtigen Anpassung der Übertragungsfunktion bei einer erfindungsgemäßen Anordnung,

Figur 8: eine erste alternative Ausführungsform zu einer Einrichtung nach Figur7 und

Figur 9: eine zweite alternative Ausführungsform zu einer Einrichtung nach Figur7.

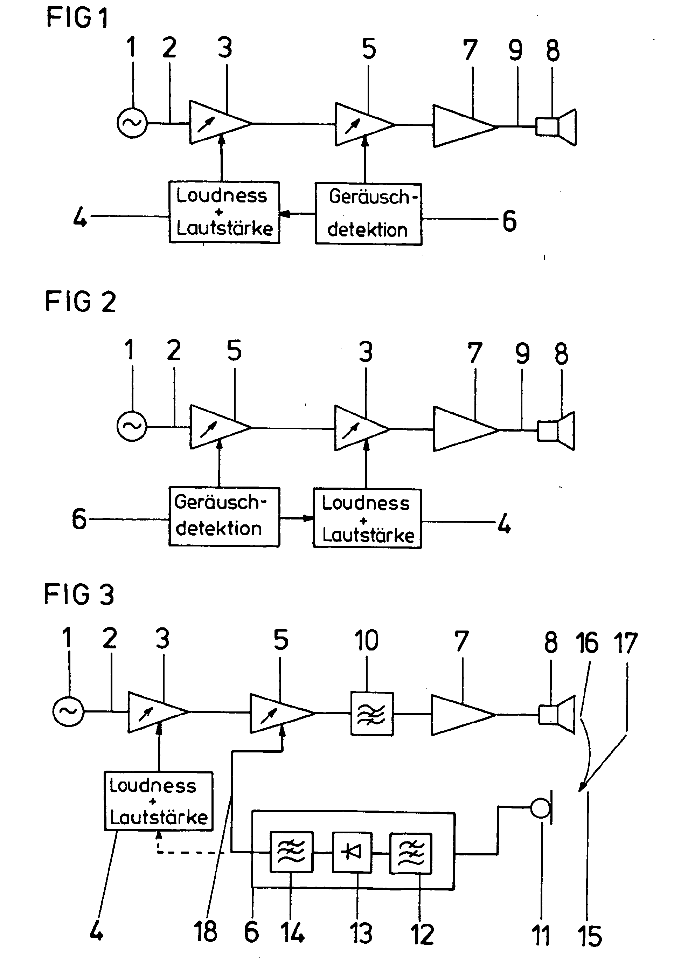

Bei der in Figur 1 gezeigten allgemeinen Ausführungsform einer erfindungsgemäßen Anordnung wird von einer Signalquelle 1 ein elektrisches Nutzsignal 2 abgegeben, das einem von einem Bediener veränderbaren Lautstärkesteller 3 zugeführt wird. Mit dem Loudnesssteller 4 ist in Weiterbildung der Erfindung jedoch nicht nur die Lautstärke veränderbar, sondern wird gleichzeitig in Abhängigkeit von der Lautstärkeeinstellung das Übertragungsverhalten des Lautstärkestellers 3 gehörrichtig angepasst (Loudness). Dem Lautstärkesteller 3 folgt ein weiterer Lautstärkesteller 5 der durch einen Geräuschdetektor 6 steuerbar ist. Der Geräuschdetektor 6 ermittelt den Pegel des Geräusches am Abhörort durch direktes oder indirektes Messen und erzeugt daraus ein Steuersignal für den Lautstärkesteller 5. Dem Lautstärkesteller 5 folgt ein Verstärker 7 zur Ansteuerung eines Lautsprechers 8. Verstärker 7 und Lautsprecher 8 können dabei getrennt angeordnet sein, oder aber beispielsweise zusammen ein aktiven Lautsprecher bilden. Die Erfindung weiterbildend wird dabei der Loudnesssteller 4 zusätzlich durch den Geräuschdetektor gesteuert.

Das Ausführungsbeispiel nach Figur 2 geht aus der Figur 1 gezeigten Anordnung dadurch hervor, dass die Reihenfolge der beiden Lautstärkesteller 3 und 5 vertauscht ist. Die Steuerung der Lautstärkesteller 5 und 3 erfolgt aber in gleicher Weise mit dem Geräuschdetektor 6 bzw. dem Loudnesssteller 4. Das bearbeitete elektrische Nutzsignal 9 am Lautsprecher 8 ist folglich - gleiche Einstellungen der Lautstärkesteller 5 und 3 sowie ein gleiches elektrisches Nutzsignal 2 vorausgesetzt - damit wieder das gleiche wie in Figur 1.

Ausgehend von dem Ausführungsbeispiel nach Figur 1 ist bei der in Figur 3 gezeigten Ausführungsform ein Hochpass 10 zwischen Lautstärkesteller 5 und Verstärker 7 geschaltet. Jedoch könnte der Hochpass 10 auch an beliebiger Stelle zwischen der Signalquelle 1 und dem Lautsprecher 8 eingefügt werden. Unter Umständen kann auch auf den Hochpass 10 verzichtet werden, wenn entweder in der Übertragungskette zwischen der Signalquelle 1 und dem Lautsprecher 8 oder in dem Lautsprecher 8 selbst eine ausreichende Dämpfung bei tiefen Tönen gewährleistet ist. Die Grenzfrequenz des Tiefpasses 10 liegt dabei bevorzugt an der unteren Hörgrenze des menschlichen Gehörs, also beispielsweise bei 20 Hertz, um den subjektiven Klangeindruck durch den Hochpass 10 nicht zu verfälschen.

Unter Tiefpassfilterung mit gleicher oder tieferer Grenzfrequenz soll nun erfindungsgemäß der Geräuschdetektor 6 den Geräuschanteil am Abhörort erfassen. Dazu erfasst der Geräuschdetektor mittels eines Mikrofons 11 am Abhörort ein Abhörsignal 15, das sich aus dem akustischen Nutzsignal vom Lautsprecher 8 sowie einem Geräusch 17 zusammensetzt. Der Geräuschdetektor 6 kann dabei im einfachsten Fall aus einem Tiefpass 12 mit einer zum Hochpass 10 in etwa korrespondierenden Grenzfrequenz bestehen, dem eine Gleichrichteinheit 13 mit anschließendem Glättungstiefpass 14 nachgeschaltet ist, die zusammen beispielsweise Spitzenwerte detektieren. In gleicher weise könnte aber auch der Mittelwert oder der quadratische Mittelwert zur Auswertung herangezogen werden. Ein so gewonnenes Steuersignal 18 dient dann zur Ansteuerung des Lautstärkestellers 5.

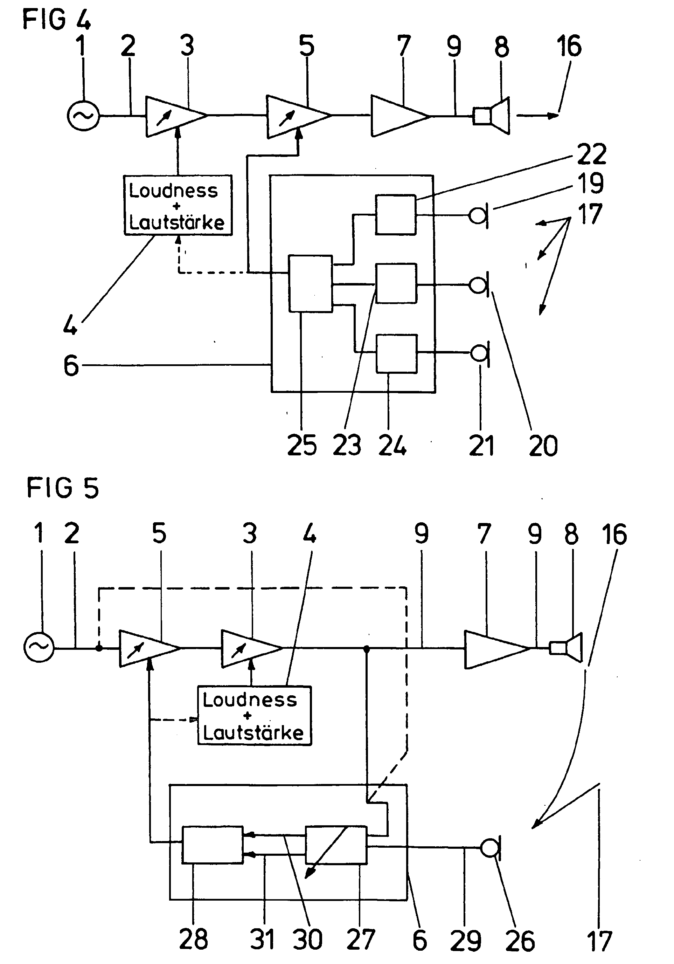

Das Ausführungsbeispiel nach Figur 4 geht aus der in Figur 1 gezeigten Ausführungsform dadurch hervor, dass der Geräuschdetektor 6 mit drei Mikrofonen 19, 20, 21, die an Orten angebracht sind, an denen nur das Störgeräusch oder Teile davon auftreten, aber nicht das akustische Nutzsignal 16 vom Lautsprecher 8 präsent ist. Das an den Mikrofonen 19, 20 und 21 auftretende Geräusch ist dabei repräsentativ für das am Abhörort auftretende Geräusch. Die Mikrofone 19, 20 und 21 werden dabei bevorzugt im Motorraum, in den Radkästen, im Kofferraum, oder in den Lüftungsschächten angeordnet. Die Signale der Mikrofone 19, 20, 21 werden durch entsprechende Pegelmesseinrichtungen 22, 23, 24, die entweder die Spitzenwerte detektieren, den Mittelwert erfassen oder den quadratischen Mittelwert bzw. deren Pegel werden anschließend in einer Auswerteeinrichtung 25 entsprechend gewichtet und beispielsweise aufaddiert.

Die Auswerteeinrichtung 25 stellt dabei wiederum das Steuersignal 18 bereit. Bei dieser Anordnung wird also davon ausgegangen, dass an den Orten der Mikrofone 19, 20 und 21 das Geräuschsignal deutlich höher ist als das vom Lautsprecher 8 bereitgestellte akustische Nutzsignal 16 an diesen Orten.

Ausgehend von der in Figur 2 gezeigten allgemeinen Ausführungsform einer erfindungsgemäßen Anordnung ist der Geräuschdetektor 6 nach Figur 5 als adaptives Filter 27 mit nachgeschaltetem Vergleicher 28 ausgebildet. Das adaptive Filter 27 erhält dabei das Abhörsignal 29, das mittels des Mikrofons 26 am Abhörort abgenommen wird. Das Abhörsignal 29 setzt sich dabei aus einem Anteil zusammen, der aus dem akustischen Nutzsignal 16 vom Lautsprecher 8 und aus einem Geräuschanteil, der von dem Geräusch am Abhörort herrührt, zusammensetzt.

Das adaptive Filter 27 filtert nun das Referenzsignal (2, 9) derart, dass das Abhörsignal 29 in einem Geräuschsignalanteil 30 und in einen Nutzsignalanteil 31 aufgespalten wird. Eine Vergleichseinrichtung 28 vergleicht Geräuschsignalanteil 30 und Nutzsignal 31 miteinander und steuert abhängig davon, wie sich beide zueinander verhalten, den Lautstärkesteller 5. Als Referenzsignal für das adaptive Filter 27 kann dabei entweder ein Signal in dem Signalzweig vor den Lautstärkestellern 3 und 5 oder in dem Signalzweig nach den Lautstärkestellern 3 und 5, also z. B. die elektrischen Nutzsignale 2, 9 verwendet werden. Jedoch ist es auch möglich, das Signal zwischen beiden Lautstärkestellern 3 und 5 abzugreifen.

Bei einer einfachen (nicht gezeigten) Ausführungsform kann das adaptive Filter 27 so ausgelegt werden, dass es lediglich den Geräuschanteil 30 ausfiltert. Der ausgefilterte Geräuschsignalanteil 30 wird dann ohne Verwendung der Vergleichsstufe 28 direkt zur Steuerung des Lautstärkestellers 5 herangezogen. Der Vorteil der weiter oben verwendeten Vergleicherstufe 28 liegt allerdings darin, dass das sogenannte "Gain-Chase-Verhalten" weitgehend unterdrückt wird. Ein "Gain-Chase-Verhalten" rührt daher, dass ein Restanteil des Nutzsignals im Geräuschsignalanteil 30 enthalten ist, welcher den gemessenen Geräuschpegel gegenüber dem tatsächlichen Anteil erhöht. Aufgrund des höheren Geräuschpegels wird dann mittels des Lautstärkestellers 5 der Nutzsignalpegel erhöht, was wiederum zur Erhöhung des Restanteils des Nutzsignals im Geräuschsignalanteil führt. Es erfolgt erneut eine Erhöhung des Nutzsignalpegels und so fort bis die maximale Lautstärke erreicht ist. Mittels des Vergleichers 28 kann aber die tatsächliche Erhöhung bzw. Nichterhöhung festgestellt werden und damit ein "Gain-Chase-Verhalten" unterbunden werden.

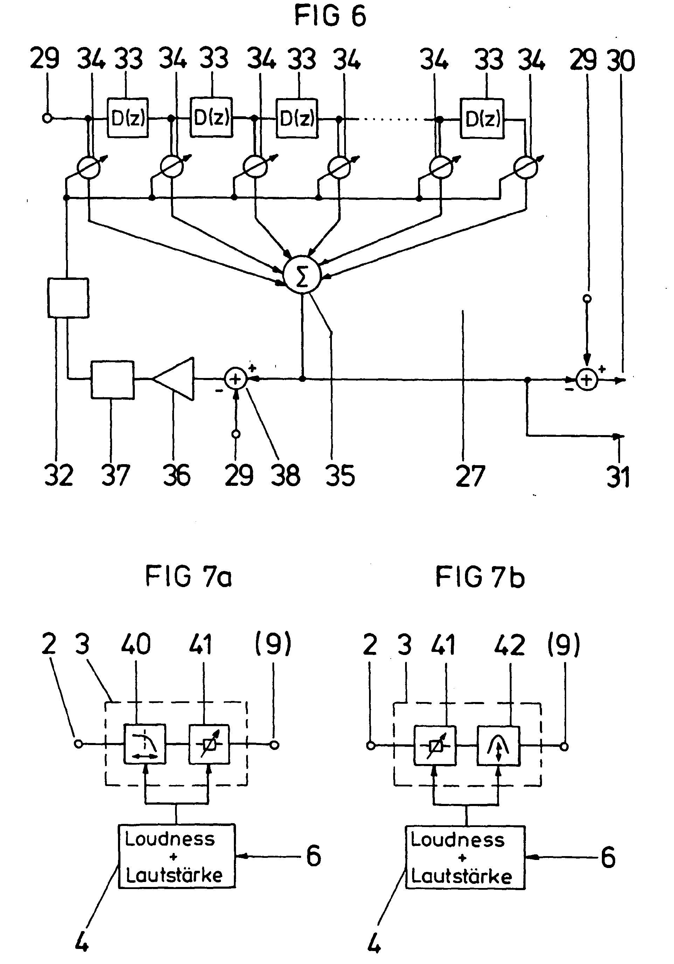

In Figur 6 ist ein Ausführungsbeispiel eines bevorzugten adaptiven Filters 27 aus Figur 5 gezeigt. Bei dem in Figur 6 gezeigten adaptiven Filter 27 wird das Referenzsignal (2, 9) einer Kette von hintereinander geschalteten Verzögerungselementen 33 zugeführt, an deren eingangs- bzw. ausgangsseitigen Abgriffen jeweils Signale abgenommen werden und über steuerbare Koeffizientenglieder 34 einem Summierer 35 zugeführt werden. Am Ausgang des Summierers 35 ist dann der Nutzsignalanteil 31 abgreifbar. Durch Vertauschen der Eingangssignale des adaptiven Filters 27 könnte aber auch der Geräuschsignalanteil am Ausgang des Summierers bereitstehen und dieser weiter verarbeitet werden.

Die Steuerung der Koeffizientenglieder 34 erfolgt nach der Methode der kleinsten mittleren Fehlerquadrate. Dazu wird das Signal am Ausgang des Summierers 35 von dem Abhörsignal 29 mittels eines Subtrahierers 38 subtrahiert und einem Verstärker 36 zugeführt. Beim Ausführungsbeispiel wird nicht nur die Methode der kleinsten mittleren Fehlerquadrate (LMS = Least Mean Square) im allgemeinen verwendet, sondern die Methode der verzögerten kleinsten mittleren Fehlerquadrate im besonderen. Dazu ist dem Verstärker 36 eine Verzögerungseinheit 37 und eine LMS-Steuereinheit 32 nachgeschaltet, deren Ausgangssignal dann zur Steuerung der Koeffizientenglieder 34 dient. Beim vorliegenden Ausführungsbeispiel wird der Geräuschsignalanteil 30 auf einfache Weise dadurch ermittelt, dass der Nutzsignalanteil 31 von dem Abhörsignal 29 mittels eines Subtrahierers 39 subtrahiert wird.

Bei dem in Figur 6 gezeigten Ausführungsbeispiel werden als Verzögerungselemente 33 in Weiterbildung der Erfindung Verzögerungselemente mit einstellbarem Phasenwinkel, wie beispielsweise Allpässe verwendet, wobei die Phasenwinkel so eingestellt werden, dass eine verzerrte Frequenzauflösung des adaptiven digitalen Filters 27 erreicht wird. Neben der als Ausführungsbeispiel gezeigten Ausführungsform als Finite Impulse Response Filter (FIR) können aber in gleicher Weise auch Infinite Impulse Response Filter oder Wellendigitalfilter verwendet werden. Außerdem kann anstelle der Methode der kleinsten Fehlerquadrate jedes andere beliebige Optimierungsverfahren herangezogen werden.

Der Vorteil der Verwendung von Verzögerungselementen mit einstellbarem Phasenwinkel gegenüber einfachen Verzögerungselementen liegt darin, dass der Filteraufwand erheblich reduziert werden kann. Vorteilhafterweise werden nämlich bei derartigen Filtern (Warped-Filtern) auf diese Weise Frequenzbereiche mit hoher Bedeutung auch mit hoher Auflösung und Frequenzbereiche mit niedriger Bedeutung mit niedriger Auflösung bearbeitet. Demzufolge kann ein gegebenes, mit begrenztem Aufwand realisierbares Filter optimal eingesetzt werden.

Verzögerungselemente mit einstellbarem Phasenwinkel wie All-pass sind gekennzeichnet durch folgende Übertragungsfunktion D(z) über der diskreten Zeit z:

$$D(z) \ = \ (z^{-1}-\lambda)/(1-\lambda z^{-1})$$

Mittels des Filterkoeffizienten $\lambda$ des Allpasses lässt sich der Phasenwinkel $\pi$ des Filterelements einstellen. Über den Filterkoeffizienten des Allpasses lässt sich aber auch die Frequenzverzerrungsfunktion des adaptiven Filters 27 einstellen (Warping-Parameter). Im übertragenen Sinne wird die lineare Frequenzachse mit Hilfe des Phasenganges der Allpässe, der bekanntlich ausschließlich von dessen Koeffizienten $\lambda$ abhängt, auf eine neue, verzerrte (= warped) Frequenzachse umgesetzt. Damit lässt sich ein Auflösungsverhalten realisieren, das beispielsweise dem menschlichen Gehör entspricht und das bei tiefen Tönen eine höhere Auflösung hat als bei höheren.

In Figur 7 sind zwei alternative Beispiele für die Ausgestaltung des Lautstärkestellers 3 gezeigt, die sowohl für sich als auch im Kombination miteinander verwendet werden können.

Das Beispiel nach Figur 7a umfasst einen Tiefpass 40, dessen Grenzfrequenz ebenso wie ein Dämpfungsglied 41 durch den Loudnesssteller 4 gesteuert werden können. Die Steuerung erfolgt dabei derart, dass je niedriger der mittels des Dämpfungsgliedes 41 einzustellende Lautstärkepegel ist, das heißt, je größer dessen Dämpfung ist, und desto höher der vom Geräuschdetektor 6 ermittelte Geräuschpegel ist, umso höher ist die Grenzfrequenz des Tiefpasses 40. Der typische Bereich der Grenzfrequenz des Tiefpasses 40 liegt dabei zwischen 50 Hz und 300 Hz. Dem Tiefpass 40 kann dabei ein in Figur 7a zwar nicht gezeigter Hochpass vorgeschaltet werden, um eine Tieftonanhebung außerhalb des Hörbereichs zu kompensieren.

Alternativ zu der in Figur 7a gezeigten Ausführungsform kann gemäß Figur 7b anstelle des Tiefpasses 40 ein Bandpass 42 mit fester Mittenfrequenz verwendet werden, dessen Güte durch den Loudnesssteller 4 entsprechend dem Dämpfungsglied 41 gesteuert wird. Bei dem Ausführungsbeispiel nach Figur 7b ist dabei noch die Reihenfolge von Dämpfungsglied 41 und Bandpass 42 gegenüber Figur 7a vertauscht. Ungeachtet dessen kann jedoch auch zudem beim Tiefpass 40 die Güte und beim Bandpass 42 die Grenzfrequenz entsprechend der Dämpfungseinstellung des Dämpfungsgliedes 41 verändert werden. Die Steuerung der Güte beim Bandpass 42 erfolgt in Abhängigkeit von dem Lautstärkepegel und dem vom Geräuschdetektor 6 ermittelten Geräuschpegel derart, dass unter Zugrundelegen einer relativ tiefen Mittenfrequenz die Güte bei niedrigen Lautstärkepegeln und/oder hohen Geräuschpegeln geringer wird.

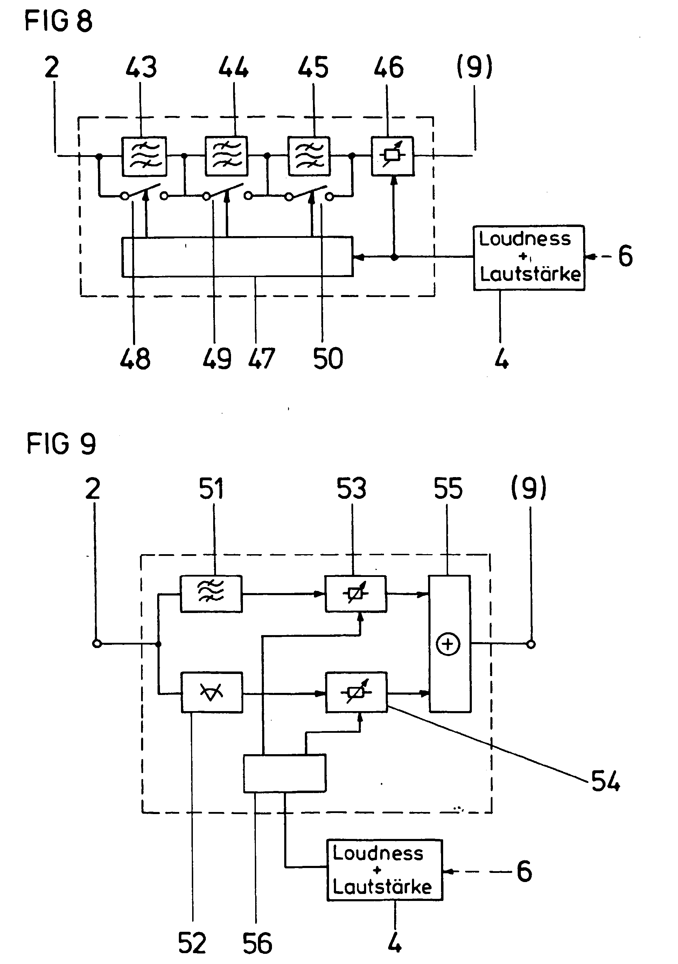

Bei einer anderen Ausführungsform eines Lautstärkestellers 3 sind gemäß Figur 8 drei Bandpässe (und/oder Tiefpässe) 43, 44, 45 zueinander und mit einem Dämpfungsglied 46 in Reihe geschaltet. Parallel zu den Bandpässen 43, 44, 45 sind durch eine Komparatoreinrichtung 47 steuerbare Schalter 48, 49, 50 geschaltet, die durch die Komparatoreinrichtung abhängig von dem von der Steuereinrichtung 4 bereitgestellten Steuersignal für das Dämpfungsglied 46 gesteuert werden derart, dass bei großen Lautstärkepegeln und/oder kleinen Geräuschpegeln sämtliche Schalter die Bandpässe 43, 44, 45 überbrücken und bei niedrigen Lautstärkepegeln und/oder großen Geräuschpegeln sämtliche Bandpässe 43, 44, 45 aktiv sind. Dazwischen werden die Bandpässe 43, 44, 45 entsprechend der gewünschten Loudnesskurve zu- bzw. weggeschaltet. Neben der gezeigten seriellen Struktur der Bandpässe 43, 44, 45 kann aber in gleicher Weise auch eine entsprechende parallele Struktur verwendet werden.

Ein weitere bevorzugte Ausführungsform eines Lautstärkesteller 3 ist in Figur 9 gezeigt. Bei diesem Ausführungsbeispiel wird das Nutzsignal 2 sowohl einem Bandpass 51 als auch einer (optionalen) Phasenkorrekturschaltung 52 zugeführt. Das Nutzsignal 2 steht dabei mit dem maximal möglichen Pegel zur Verfügung. Dem Bandpass 51 und der Phasenkorrekturschaltung 52 sind jeweils ein steuerbares Dämpfungsglied 53 bzw. 54 nachgeschaltet. Die Ausgänge der Dämpfungsglieder 53 und 54 sind schließlich mit den Eingängen eines Addierers 55 verbunden, an dessen Ausgang dann das gedämpfte und in der Loudness korrigierte Nutzsignal zur Verfügung steht.

Die Steuerung der steuerbaren Dämpfungsglieder 53 und 54 erfolgt mittels einer Steuerschaltung 56, welche die Dämpfungsglieder 53 und 55 in Abhängigkeit von einem entsprechenden Steuersignal des Loudnessstellers 4 einstellt. Die Steuerung der Dämpfungsglieder 53 und 54 erfolgt dabei derart, dass bei hohen Lautstärken und/oder geringen Geräuschpegeln, das heißt bei geringer Dämpfung des Dämpfungsglieds 54 das Dämpfungsglied 59 eine hohe Dämpfung hat. Bei der Zunahme der Dämpfung über das Dämpfungsglied 54 nimmt die Dämpfung des Dämpfungsgliedes 59 ab und zwar in dem Maße, dass die geforderte Loudnesskurve erfüllt wird. Ab einem bestimmten Punkt nehmen dann die Dämpfungen beider Dämpfungsglieder 52 und 54 zu, wobei die Dämpfung des Dämpfungsgliedes 54 deutlich stärker ansteigt als die Dämpfung des Dämpfungsgliedes 53.

## Patentansprüche

1. Vorrichtung zum geräuschabhängigen Einstellen der Lautstärke eines aus einer Signalquelle (1) mit einem elektrischen Nutzsignal (2, 9) gespeisten Lautsprechers (8) an einem mit Geräusch (17) erfüllten Abhörort mit

   zwei in Reihe zueinander sowie zwischen Signalquelle (1) und Lautsprecher (8) geschalteten Lautstärkestellern (3, 5), von denen der eine (3) manuell steuerbar und mit einer Einrichtung (4) gekoppelt ist, zum gehörrichtigen Anpassen der übertragungsfunktion zwischen Signalquelle (1) und Lautsprecher (8) entsprechend einer Loudnesskurve an die eingestellte Lautstärke, und wobei der andere Laustärkesteller (5) durch ein Steuersignal (18) steuerbar ist, wobei ein Geräuschdetektor (6) vorhanden ist, zum Ermitteln des Pegels des Geräusches (17) und Erzeugen des Steuersignals (18) für den anderen Lautstärkesteller (5) entsprechend dem Pegel des Geräusches (17) .

2. Vorrichtung zum geräuschabhängigen Einstellen der Lautstärke nach Anspruch 1, bei der die Einrichtung (4) zum gehörrichtigen Anpassen durch mindestens ein (weiteres) Steuersignal des Geräuschdetektors (6) gesteuert wird.

3. Vorrichtung zum geräuschabhängigen Einstellen der Lautstärke nach Anspruch 1 oder 2, bei der

die Einrichtung (4) zum gehörrichtigen Anpassen der Übertragungsfunktion mindestens zwei Filter (43, 44, 45) mit unterschiedlichen Grenz-/Mittenfrequenzen aufweist, die durch (jeweils) ein Steuersignal (18) des Geräuschdetektors (6) gesteuert werden.

4.  Vorrichtung zum geräuschabhängigen Einstellen der Lautstärke nach einem der Ansprüche 1 bis 3, bei der
der Geräuschdetektor (6) das Geräusch (17) in mindestens zwei unterschiedlichen spektralen Bereichen auswertet und dementsprechende Steuersignale (18) erzeugt.

5.  Vorrichtung zum geräuschabhängigen Einstellen der Lautstärke nach einem der Ansprüche 1 bis 4, bei der
ein von dem Lautsprecher (8) abgestrahltes akustisches Nutzsignal (16) Signale mit Frequenzen oberhalb einer bestimmten Grenzfrequenz umfasst und der Geräuschdetektor (6) Geräusche unterhalb dieser bestimmten Grenzfrequenz auswertet.

6.  Vorrichtung zum geräuschabhängigen Einstellen der Lautstärke nach einem der Ansprüche 1 bis 4, bei der
der Geräuschdetektor (6) Geräusche (17) an mindestens einem Ort, an dem kein oder nur ein geringes akustisches Nutzsignal (16) auftritt und an dem das Geräusch in einer festen Beziehung zum Geräusch (17) am Abhörort steht, auswertet.

7.  Vorrichtung zum geräuschabhängigen Einstellen der Lautstärke nach einem der Ansprüche 1 bis 4, bei der
der Geräuschdetektor (6) ein sich aus akustischem Nutzsignal (16) und Geräusch (17) zusammensetzendes Abhörsignal (15) am Abhörort und das von der Signalquelle (1) bereitgestellte elektrische Nutzsignal (2, 9) auswertet.

8.  Vorrichtung zum geräuschabhängigen Einstellen der Lautstärke nach Anspruch 7, bei der der Geräuschdetektor (6) aufweist

    einen Schallaufnehmer (26) zur Erzeugung eines elektrischen Abhörsignals aus dem akustischen Nutzsignal (16) und dem diesem überlagerten Geräusch (17) am Abhörort,
    einen dem Schallaufnehmer (26) nachgeschalteten Extrahierer (27) zum Extrahieren des im Abhörsignal (15) enthaltenen Geräuschanteils (17), und
    eine dem Extrahierer (27) nachgeschaltete Steuereinrichtung (28), die den Geräuschanteil (30) des Abhörsignals (15) und mindestens ein aus dem Abhörsignal (15) abgeleitetes Signal (31) erhält und die aus beidem das Steuersignal (18) für den anderen Lautstärkesteller (5) erzeugt.

9.  Vorrichtung zum geräuschabhängigen Einstellen der Lautstärke nach Anspruch 8, bei der
ein aus dem Abhörsignal (15) abgeleitetes Signal (31) dem Nutzsignalanteil (16) des Abhörsignals (15) entspricht.

10. Vorrichtung zum geräuschabhängigen Einstellen der Lautstärke nach Anspruch 8, bei der
ein aus dem Abhörsignal (15) abgeleitetes Signal (31) der Summe aus Nutzsignalanteil (16) und Geräuschanteil (17) des Abhörsignals (15) entspricht.

11. Vorrichtung zum geräuschabhängigen Einstellen der Lautstärke nach Anspruch 8, 9 oder 10, bei der
ein aus dem Abhörsignal (15) abgeleitetes Signal (31) durch den Extrahierer (27) bereitgestellt wird.

12. Vorrichtung zum geräuschabhängigen Einstellen der Lautstärke nach einem der Ansprüche 8 bis 11, bei der
der Extrahierer (27) mindestens ein adaptives Filter (29 bis 38) aufweist.

13. Vorrichtung zum geräuschabhängigen Einstellen der Lautstärke nach einem der Ansprüche 8 bis 12, bei der
der Extrahierer (27) mit der Signalquelle (1) verbunden ist und von dieser das elektrische Nutzsignal (2, 9) erhält.

14. Vorrichtung zum geräuschabhängigen Einstellen der Lautstärke nach einem der Ansprüche 8 bis 12, bei der
der Extrahierer (27) mit dem Eingang des Lautsprechers (8) verbunden ist und von dort das elektrische Nutzsignal (2, 9) erhält.

15. Vorrichtung zum geräuschabhängigen Einstellen der Lautstärke nach einem der Ansprüche 12 bis 14, bei der
das adaptive Filter umfasst

    Verzögerungselemente (33) und ein mit den Verzögerungselementen (33) gekoppeltes Koeffizientennetzwerk (34), die aus dem ihr zugeführten Abhörsignal (15) durch Filterung ein Ausgangssignal (31) erzeugt, und
    eine Steuereinheit (36, 37, 38) zur Steuerung des Koeffizientennetzwerkes (34) derart, dass das Ausgangssignal (31) gegenüber einem Referenzsignal (2, 9) optimiert wird, wobei
    als Verzögerungselemente (33) Filterelemente mit einstellbaren Phasenwinkeln vorgesehen sind und
    die Phasenwinkel eine verzerrte Frequenzauflösung ergebend eingestellt sind, wobei das Ausgangssignal (31) zur Erzeugung des Steuersignals (18) herangezogen wird.

16. Vorrichtung zum geräuschabhängigen Einstellen der Lautstärke nach Anspruch 15, bei der als Referenzsignal (32) das elektrische Nutzsignal (2, 9) vorgesehen ist.

17. Vorrichtung zum geräuschabhängigen Einstellen der Lautstärke nach Anspruch 15 oder 16, bei der als Filterelemente mit einstellbaren Phasenwinkeln Allpässe vorgesehen sind.

18. Vorrichtung zum geräuschabhängigen Einstellen der Lautstärke nach einem der Ansprüche 12 bis 17, bei der die Optimierung des Ausgangssignals (31) mittels der Methode der kleinsten mittleren Fehlerquadrate.

19. Vorrichtung zum geräuschabhängigen Einstellen der Lautstärke nach einem der Ansprüche 1 bis 14, bei der die Einrichtung zum gehörrichtigen Anpassen der Übertragungsfunktion eine Loudness-Filteranordnung (40 bis 56) zur Anhebung des tieferen Hörfrequenzbereichs gegenüber dem mittleren Hörfrequenzbereich aufweist.

20. Vorrichtung zum geräuschabhängigen Einstellen der Lautstärke nach Anspruch 15, bei der zum gehörrichtigen Anpassen der Übertragungsfunktion die Filtergüte der Loudness-Filteranordnung (40 bis 56) geräuschpegelabhängig angepasst wird.

21. Vorrichtung zum geräuschabhängigen Einstellen der Lautstärke nach Anspruch 19 oder 20, bei der zum gehörrichtigen Anpassen der Übertragungsfunktion die Filtergrenzfrequenz der Loudness-Filteranordnung (40 bis 56) geräuschpegelabhängig angepasst wird.

22. Vorrichtung zum geräuschabhängigen Einstellen der Lautstärke nach Anspruch 19, bei der die Einrichtung zum gehörrichtigen Anpassen der Übertragungsfunktion die Loudness-Filteranordnung (40 bis 56) mindestens zwei Filter (43, 44, 45) zur Anhebung des tieferen Hörfrequenzbereichs gegenüber dem mittleren Hörfrequenzbereich aufweist und zum gehörrichtigen Anpassen der Übertragungsfunktion diese einzelnen Filter (43, 44, 45) geräuschpegelabhängig zu- oder abgeschaltet werden.

23. Vorrichtung zum geräuschabhängigen Einstellen der Lautstärke nach einem der Ansprüche 2 bis 18, bei der

die Einrichtung zum gehörrichtigen Anpassen der Übertragungsfunktion aufweist eine durch das elektrische Nutzsignal (2, 9) angesteuerten Filtereinrichtung (51) zur frequenzselektiven Filterung des elektrischen Nutzsignals (2, 9), eine der Filtereinrichtung (51) nachgeschalteten ersten steuerbaren Dämpfungseinrichtung (53), eine ebenfalls durch das elektrische Nutzsignal (2, 9) angesteuerten zweiten steuerbaren Dämpfungseinrichtung (54), eine mit den beiden Dämpfungseinrichtungen (53, 54) verbundenen Addiereinrichtung (55) zur Erzeugung eines gehörrichtigen Ausgangssignals und eine mit den beiden Dämpfungseinrichtungen (53, 54) verbundenen Steuereinrichtung (56) zur Steuerung der beiden Dämpfungseinrichtungen (53, 54) entsprechend einer vorgegebenen Lautstärke und/oder einem Geräuschpegel.

24. Vorrichtung zum geräuschabhängigen Einstellen der Lautstärke nach Anspruch 23, bei der die Filtereinrichtung (51) ein bestimmtes Phasenverhalten aufweist und bei der eine ebenfalls durch das elektrische Nutzsignal (2, 9) angesteuerte Phasenschiebereinrichtung (52) zur Erzeugung eines zur Filtereinrichtung (51) identischen Phasenverhaltens vorgesehen ist, welche vor die zweite Dämpfungseinrichtung (54) geschaltet ist.

**Claims**

1. Apparatus for the noise-dependent adjustment of the volume of a loud speaker (8), which is supplied with a useful electrical signal (2,9) from a signal source (1), at a listening location filled with noise (17) including

two volume controllers (3,5), which are connected in series with one another and between the signal source (1) and loudspeaker (8) and of which one (3) is manually controllable and is coupled with a device (4) for acoustically correctly matching the transmission function between the signal source (1) and loudspeaker (8) in accordance with a loudness curve to the adjusted volume and wherein the other volume controller (5) is controllable by means of a control signal (8), wherein a noise detector (6) is present for determining the level of the noise (17) and producing the control signal (18) for the other volume controller (6) in accordance with the level of the noise (17).

2. Apparatus for the noise-dependent adjustment of the volume as claimed in claim 1, in which the device (14) for the acoustically correct matching is controlled by at least one (further) control signal from the noise detector (6).

3.  Apparatus for the noise-dependent adjustment of the volume as claimed in claim 1 or 2, in which the device (4) for the acoustically correct matching of the transmission function includes at least two filters (43,44,45) with different threshold/mean frequencies, which are controlled by a (respective) control signal (18) from the noise detector (6).

4.  Apparatus for the noise-dependent adjustment of the volume as claimed in one of claims 1 to 3, in which the noise detector (6) analyses the noise (17) in at least two different spectral ranges and produces corresponding control signals (18).

5.  Apparatus for the noise-dependent adjustment of the volume as claimed in one of claims 1 to 4, in which a useful acoustic signal (16) radiated by the loudspeaker (8) includes signals with frequencies above a predetermined threshold frequency and the noise detector (6) analyses noises above this predetermined threshold frequency.

6.  Apparatus for the noise-dependent adjustment of the volume as claimed in one of claims 1 to 4, in which the noise detector (6) analyses noises (17) at at least one location, at which no or only a small useful acoustic signal (16) appears and at which the noise is in a fixed relationship to the noise (17) at the listening location.

7.  Apparatus for the noise-dependent adjustment of the volume as claimed in one of claims 1 to 4, in which the noise detector (6) analyses a listening signal (16), which is composed of a useful acoustic signal (16) and noise (17), at the listening location and the useful electrical signal (2,9) provided by the signal source (1).

8.  Apparatus for the noise-dependent adjustment of the volume as claimed in claim 7, in which the noise detector (6) includes a sound receiver (26) for generating an electrical listening signal from the useful acoustic signal (16) and the noise (17) at the listening location superimposed on it, an extractor (27) connected to the output of the noise receiver (26) for extracting the noise component (17) contained in the listening signal (15) and a control device (28) which is connected to the output of the extractor (27) and receives the noise component (30) of the listening signal (15) and at least one signal (13) derived from the listening signal (15) and which produces from both of these the control signal (18) for the other volume controller (5).

9.  Apparatus for the noise-dependent adjustment of the volume as claimed in claim 8, in which a signal (31) derived from a listening signal (15) corresponds to the useful signal component (16) of the listening signal (15).

10. Apparatus for the noise-dependent adjustment of the volume as claimed in claim 8, in which a signal (31) derived from a listening signal (15) corresponds to the sum of the useful signal component (16) and noise component (17) of the listening signal (15).

11. Apparatus for the noise-dependent adjustment of the volume as claimed in claim 8, 9 or 10, in which a signal (31) derived from the listening signal (15) is provided by the extractor (27).

12. Apparatus for the noise-dependent adjustment of the volume as claimed in one of claims 8 to 11, in which the extractor (27) includes at least one adaptive filter (29 to 38).

13. Apparatus for the noise-dependent adjustment of the volume as claimed in one of claims 8 to 12, in which the extractor (27) is connected to the signal source (1) and receives the useful electrical signal (2,9) from it.

14. Apparatus for the noise-dependent adjustment of the volume as claimed in one of claims 8 to 12, in which the extractor (27) is connected to the input of the loudspeaker (8) and receives the useful electrical signal (2,9) from there.

15. Apparatus for the noise-dependent adjustment of the volume as claimed in one of claims 12 to 14, in which the adaptive filter includes delay elements (33) and a coefficient network (34), which is coupled to the delay elements (33) and produces an output signal (31) from the listening signal (15) supplied to it by filtering, and a control unit (36,37,38) for controlling the coefficient network (34) such that the output signal (31) is optimised with respect to a reference signal (2,9), wherein filter elements with adjustable phase angles are provided as the delay elements (33) and the phase angles are set to produce a distorted frequency resolution, whereby the output signal (31) is used for producing the control signal (18).

16. Apparatus for the noise-dependent adjustment of the volume as claimed in claim 15, in which the useful electrical signal (2,9) is provided as the reference signal (32).

17. Apparatus for the noise-dependent adjustment of the volume as claimed in claim 15 or 16, in which all-pass networks are provided as the filter elements with adjustable phase angles.

18. Apparatus for the noise-dependent adjustment of the volume as claimed in one of claims 12 to 17, in which the optimisation of the output signal (31) is effected by means of the mean square error method.

19. Apparatus for the noise-dependent adjustment of the volume as claimed in one of claims 1 or 14, in which the device for acoustically correctly matching the transmission function includes a loudness filter device (40 to 56) for boosting the lower audible frequency range with respect to the middle audible frequency range.

20. Apparatus for the noise-dependent adjustment of the volume as claimed in claim 15, in which the filter quality of the loudness filter device (40 to 56) is adjusted in dependence on the noise level for the acoustically correct matching of the transmission function.

21. Apparatus for the noise-dependent adjustment of the volume as claimed in claim 19 or 20, in which the filter threshold frequency of the loudness filter device (40 to 56) is adjusted in dependence on the noise level for the acoustically correct matching of the transmission function.

22. Apparatus for the noise-dependent adjustment of the volume as claimed in claim 19, in which the device for the acoustically correct matching of the transmission function of the loudness filter device (40 to 56) includes at least two filters (43,44,45) for boosting the lower audible frequency range with respect to the middle audible frequency range and these individual filters (43,44,45) are switched on and off in dependence on the noise level for the acoustically correct matching of the transmission function.

23. Apparatus for the noise-dependent adjustment of the volume as claimed in one of claims 2 to 18, in which the device for the acoustically correct matching of the transmission function includes a filter device (15), which is controlled by the useful electrical signal (2,9), for frequency selective filtering of the useful electrical signal (2,9), a first controllable damping device (53) which is connected to the output of the filter device (51), a second controllable damping device (54), which is also controlled by the useful electrical signals (2,9), and an adder (55), which is connected to the two damping devices (53,54), for producing an acoustically correct output signal and a control device (56), which is connected to the two damping devices (53,54), for controlling the two damping devices (53,54) in accordance with a predetermined volume and/or a noise level.

24. Apparatus for the noise-dependent adjustment of the volume as claimed in claim 23, in which the filter device (51) has a predetermined phase performance and in which a phase shifting device (52), which is also controlled by the useful electrical signal (2,9), is provided for producing a phase performance identical to the filter device (51), which is connected to the input of the second damping device (54).

**Revendications**

1. Système pour le réglage en fonction du bruit du volume sonore d'un haut-parleur (8) recevant un signal électrique utile (2, 9) d'une source de signaux (1) sur un lieu d'écoute saturé de bruit (17), comprenant deux régulateurs de volume (3, 5) montés en série l'un par rapport à l'autre et entre la source de signaux (1) et le haut-parleur (8), dont le premier (3) est commandable manuellement et est couplé à un dispositif (4) pour l'ajustement à l'écoute et suivant le volume réglé de la fonction de transmission entre la source de signaux (1) et le haut-parleur (8) conformément à une courbe d'intensité sonore, l'autre régulateur de volume (5) étant commandable par un signal de commande (18),
où un détecteur de bruit (6) est présent pour déterminer le niveau du bruit (17) et générer le signal de commande (18) pour l'autre régulateur de volume (5) en fonction du niveau du bruit (17).

2. Système pour le réglage de volume sonore en fonction du bruit selon la revendication 1, où le dispositif (4) pour l'ajustement à l'écoute est commandé par au moins un (autre) signal de commande du détecteur de bruit (6).

3. Système pour le réglage de volume sonore en fonction du bruit selon la revendication 1 ou la revendication 2, où le dispositif (4) pour l'ajustement à l'écoute de la fonction de transmission comprend au moins deux filtres (43, 44, 45) de fréquences limites/centrales différentes, qui sont commandés (chacun) par un signal de commande (18) du détecteur de bruit (6).

4. Système pour le réglage de volume sonore en fonction du bruit selon l'une des revendications 1 à 3, où le détecteur de bruit (6) analyse le bruit (17) dans au moins deux plages spectrales différentes et génère des signaux de commande (18) en conséquence.

5. Système pour le réglage de volume sonore en fonction du bruit selon l'une des revendications 1 à 4, où un signal acoustique utile (16) émis par le haut-parleur (8) comprend des signaux de fréquences supérieures à une fréquence limite définie, et où le détecteur de bruit (6) analyse les bruits en-dessous de cette fréquence limite définie.

6. Système pour le réglage de volume sonore en fonction du bruit selon l'une des revendications 1 à 4, où le détecteur de bruit (6) analyse les bruits (17) au moins sur un lieu où ne parvient aucun signal acoustique utile (16), ou seulement un signal acoustique utile faible, et où le bruit est en relation fixe avec le bruit (17) sur le lieu d'écoute.

7. Système pour le réglage de volume sonore en fonction du bruit selon l'une des revendications 1 à 4, où le détecteur de bruit (6) analyse sur le lieu d'écoute un signal d'écoute (15) composé du signal acoustique utile (16) et du bruit (17) et le signal électrique utile (2, 9) délivré par la source de signaux (1).

8. Système pour le réglage de volume sonore en fonction du bruit selon la revendication 7, où le détecteur de bruit (6) comprend
un capteur acoustique (26) pour générer un signal électrique d'écoute à partir du signal acoustique utile (16) et du bruit (17) superposé à celui-ci sur le lieu d'écoute,
un extracteur (27) monté en aval du capteur acoustique (26) pour extraire la part de bruit (17) contenue dans le signal d'écoute (15), et
un dispositif de commande (28) monté en aval de l'extracteur (27), lequel reçoit la part de bruit (30) du signal d'écoute (15), et au moins un signal (31) dérivé du signal d'écoute (15), et génère à partir de ceux-ci le signal de commande (18) pour l'autre régulateur de volume (5).

9. Système pour le réglage de volume sonore en fonction du bruit selon la revendication 8, où
un signal (31) dérivé du signal d'écoute (15) correspond à la part de signal utile (16) du signal d'écoute (15).

10. Système pour le réglage de volume sonore en fonction du bruit selon la revendication 8, où
un signal (31) dérivé du signal d'écoute (15) correspond à la somme de la part de signal utile (16) et de la part de bruit (17) du signal d'écoute (15).

11. Système pour le réglage de volume sonore en fonction du bruit selon la revendication 8, 9 ou 10, où un signal (31) dérivé du signal d'écoute (15) est délivré par l'extracteur (27).

12. Système pour le réglage de volume sonore en fonction du bruit selon l'une des revendications 8 à 11, où l'extracteur (27) comprend au moins un filtre adaptatif (29 à 38).

13. Système pour le réglage de volume sonore en fonction du bruit selon l'une des revendications 8 à 12, où l'extracteur (27) est relié à la source de signaux (1) et reçoit le signal électrique utile (2, 9) de celle-ci.

14. Système pour le réglage de volume sonore en fonction du bruit selon l'une des revendications 8 à 12, où

l'extracteur (27) est relié à l'entrée du haut-parleur (8) et en reçoit le signal électrique utile (2, 9).

15. Système pour le réglage de volume sonore en fonction du bruit selon l'une des revendications 12 à 14, où le filtre adaptatif comprend
des éléments de temporisation (33) et un réseau de coefficients (34) couplé aux éléments de temporisation (33), générant un signal de sortie (31) par filtrage à partir du signal d'écoute (15) qui lui est transmis, et
une unité de commande (36, 37, 38) pour commander le réseau de coefficients (34) de manière à optimiser le signal de sortie (31) par rapport à un signal de référence (2, 9),
des éléments de filtrage à angles de phase réglables étant prévus comme éléments de temporisation (33), et
les angles de phase étant réglés pour qu'il en résulte une résolution en fréquence distordue, et
le signal de sortie (31) étant utilisé pour générer le signal de commande (18).

16. Système pour le réglage de volume sonore en fonction du bruit selon la revendication 15, où
le signal électrique utile (2, 9) est prévu comme signal de référence (32).

17. Système pour le réglage de volume sonore en fonction du bruit selon la revendication 15 ou la revendication 16, où
des filtres passe-tout sont prévus comme éléments de filtrage à angles de phase réglables.

18. Système pour le réglage de volume sonore en fonction du bruit selon l'une des revendications 12 à 17, où
l'optimisation du signal de sortie (31) est effectuée au moyen de la méthode des moindres carrés d'erreur moyens.

19. Système pour le réglage de volume sonore en fonction du bruit selon l'une des revendications 1 à 14, où le dispositif pour l'ajustement à l'écoute de la fonction de transmission comprend un agencement de filtres d'intensité sonore (40 à 56) pour l'élévation de la plage de fréquences sonores basse par rapport à la plage de fréquences sonores centrale.

20. Système pour le réglage de volume sonore en fonction du bruit selon la revendication 15, où
pour l'ajustement à l'écoute de la fonction de transmission, la qualité de filtrage de l'agencement de filtres d'intensité sonore (40 à 56) est adaptée en fonction du niveau de bruit.

21. Système pour le réglage de volume sonore en fonction du bruit selon la revendication 19 ou la revendication 20, où

pour l'ajustement à l'écoute de la fonction de transmission, la fréquence limite de filtrage de l'agencement de filtres d'intensité sonore (40 à 56) est adaptée en fonction du niveau de bruit.

22. Système pour le réglage de volume sonore en fonction du bruit selon la revendication 19, où
le dispositif pour l'ajustement à l'écoute de la fonction de transmission comprend l'agencement de filtres d'intensité sonore (40 à 56) avec au moins deux filtres (43, 44, 45) pour l'élévation de la plage de fréquences sonores basse par rapport à la plage de fréquences sonores centrale, et où
pour l'ajustement à l'écoute de la fonction de transmission, ces différents filtres (43, 44, 45) sont activés ou désactivés en fonction du niveau de bruit.

23. Système pour le réglage de volume sonore en fonction du bruit selon l'une des revendications 2 à 18, où
le dispositif pour l'ajustement à l'écoute de la fonction de transmission comprend
un dispositif de filtrage (51) commandé par le signal électrique utile (2, 9) pour le filtrage du signal électrique utile (2, 9) par sélection de fréquences,
un premier dispositif d'affaiblissement (53) commandable, monté en aval du dispositif de filtrage (51),
un deuxième dispositif d'affaiblissement (54) commandable, également commandé par le signal électrique utile (2, 9),
un dispositif additionneur (55) relié aux deux dispositifs d'affaiblissement (53, 54) pour générer un signal de sortie ajusté à l'écoute, et
un dispositif de commande (56) relié aux deux dispositifs d'affaiblissement (53, 54), pour commander les deux dispositifs d'affaiblissement (53, 54) en fonction d'un volume et/ou d'un niveau de bruit définis.

24. Système pour le réglage de volume sonore en fonction du bruit selon la revendication 23, où
le dispositif de filtrage (51) présente un comportement de phase défini et où un dispositif de décalage de phase (52), également commandé par le signal électrique utile (2, 9), est prévu pour générer un comportement de phase identique au dispositif de filtrage (51), et est monté en amont du deuxième dispositif d'affaiblissement (54).

FIG 1

FIG 2

FIG 3

FIG 4

FIG 5

# FIG 6

# FIG 7a

# FIG 7b

## FIG 8

Loudness + Lautstärke

## FIG 9

Loudness + Lautstärke

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5034984 A
- US 4944018 A
- DE 19832472
- JP 11225030 A
- EP 0319777 A
- US 4677389 A